(19) Europäisches Patentamt / European Patent Office / Office européen des brevets

(11) **EP 2 315 273 B1**

(12) **EUROPEAN PATENT SPECIFICATION**

(45) Date of publication and mention
of the grant of the patent:
**31.08.2016  Bulletin 2016/35**

(51) Int Cl.:
*H01L 27/15* (2006.01)    *H01L 33/14* (2010.01)
*H01L 33/38* (2010.01)    *H01L 33/40* (2010.01)
*H01L 33/20* (2010.01)

(21) Application number: **10188577.0**

(22) Date of filing: **22.10.2010**

(54) **Light emitting device and light emitting device package**

Lichtemittierende Vorrichtung und Gehäuse für lichtemittierende Vorrichtung

Dispositif électroluminescent et conditionnement de dispositif électroluminescent

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.10.2009  KR 20090100653**

(43) Date of publication of application:
**27.04.2011  Bulletin 2011/17**

(73) Proprietor: **LG Innotek Co., Ltd.
Seoul 100-714 (KR)**

(72) Inventor: **Hwang, Sung Min
100-714, Seoul (KR)**

(74) Representative: **Cabinet Plasseraud
66, rue de la Chaussée d'Antin
75440 Paris Cedex 09 (FR)**

(56) References cited:
**EP-A1- 2 224 503        WO-A1-2007/036164
DE-A1-102007 019 776     JP-B2- 2 927 158
US-A1- 2003 222 269      US-A1- 2006 157 718
US-A1- 2007 284 606      US-A1- 2009 072 249**

- **CHUANG R W ET AL: "Improved ESD properties
  by combining GaN-based light-emitting diode
  with MOS capacitor", SOLID STATE
  ELECTRONICS, ELSEVIER SCIENCE
  PUBLISHERS, BARKING, GB, vol. 52, no. 7, 1 July
  2008 (2008-07-01), pages 1043-1046,
  XP022714845, ISSN: 0038-1101, DOI:
  DOI:10.1016/J.SSE.2008.03.005 [retrieved on
  2008-04-29]**

**Description**

**BACKGROUND**

The application relates to a light emitting device, a light emitting device package, and a lighting system.

A light emitting device (LED) includes a p-n junction diode having a characteristic of converting electric energy into optical energy. The p-n junction diode can be formed by combining group III-V elements of the periodic table. The LED can represent various colors by adjusting the compositional ratio of compound semiconductors.

When a forward voltage is applied to the LED, electrons of an n layer are combined with holes of a p layer, so that energy corresponding to an energy gap between a conduction band and a valance band may be generated. This energy is mainly realized as heat or light, and the LED emits the energy as the light.

A nitride semiconductor represents superior thermal stability and wide band gap energy so that the nitride semiconductor has been spotlighted in the field of optical devices and high-power electronic devices. In particular, blue, green, and UV light emitting devices employing the nitride semiconductor have already been developed and extensively used.

According to the related art, a current may flow reversely when electrostatic discharge (ESD) occurs, thereby causing damage to an active layer formed in a light emitting area.

In order to prevent the LED from being damaged due to the ESD, according to the related art, Zener diode is mounted in a package in the reverse direction of the LED while connecting the Zener diode with the LED in parallel. Thus, when a constant voltage is applied, a current flows to the LED so that the LED emits the light. In addition, when the ESD occurs, the current flows to the Zener diode, so that the LED can be prevented from being damaged.

However, according to the related art, the Zener diode is mounted in the package, so that light absorption may be lowered.

US2007/0284606 A1 proposes to utilize an integrated thick-film capacitor or a Schottky barrier for ESD protection.

In a vertical type light emitting device according to the related art, n and p type electrodes are formed at the top and bottom of the light emitting device, respectively, for current injection.

In this case, electrons and holes injected by the n and p type electrodes carry to an active layer and are combined with each other to emit light. The light may be emitted to the outside, or reflected by the n type electrode and disappeared inside the light emitting device. In other words, according to the related art, light emitted under the n type electrode is reflected by the n type electrode, so that light emission efficiency may be reduced.

In addition, according to the related art, the light reflected by the n type electrode is re-absorbed, so that heat may be emitted.

According to the related art, the life span and the reliability of the light emitting device may be lowered due to current crowding.

To solve this problem WO 2007/036164 A1 and JP2927158 B2 propose to utilize a current blocking layer and a reflective layer placed under the top electrode.

**BRIEF SUMMARY**

The embodiment of the invention as defined in claim 1 provides a light emitting device, a light emitting device package, and a lighting system, capable of preventing the light emitting device from being damaged due to ESD while preventing light absorption from being lowered.

The embodiment provides a light emitting device, a light emitting device package, and a lighting system, capable of improving light extraction efficiency while enhancing current spreading efficiency.

According to the embodiment, a light emitting device package includes a package body, third and fourth electrode layers installed in the package body, and a light emitting device electrically connected to the third and fourth electrode layers.

According to the embodiment, a lighting system includes a substrate and a light emitting module including a light emitting device package over the substrate. The light emitting device package includes a package body, third and fourth electrode layers installed in the package body, and the light emitting device electrically connected to the third and fourth electrode layers.

**BRIEF DESCRIPTION OF THE DRAWINGS**

FIG. 1 is a sectional view showing a light emitting device according to a first illustrative example;

FIG. 2 is a circuit diagram showing a light emitting device according to the embodiment;

FIG. 3 is a view showing the waveform of the light emitting device according to the embodiment when ESD occurs;

FIGS. 4 to 7 are sectional views showing the manufacturing process of the light emitting device according to the first illustrative example;

FIG. 8 is a sectional view showing a light emitting device according to a second illustrative example;

FIG. 9 is a sectional view showing a light emitting device according to an embodiment of the invention as claimed;

FIG. 10 is a sectional view showing a light emitting device package according to the embodiment;

FIG. 11 is a perspective view showing a lighting unit according to the embodiment; and

FIG. 12 is an exploded perspective view showing a backlight unit according to the embodiment.

## DETAILED DESCRIPTION OF THE EMBODIMENTS

Hereinafter, a light emitting device, a light emitting device package, and a lighting system according to the embodiment will be described with respect to accompanying drawings.

In the description of embodiments, it will be understood that when a layer (or film) is referred to as being 'on' another layer or substrate, it can be directly on another layer or substrate, or intervening layers may also be present. Further, it will be understood that when a layer is referred to as being 'under' another layer, it can be directly under another layer, and one or more intervening layers may also be present. In addition, it will also be understood that when a layer is referred to as being 'between' two layers, it can be the only layer between the two layers, or one or more intervening layers may also be present.

(Illustrative example)

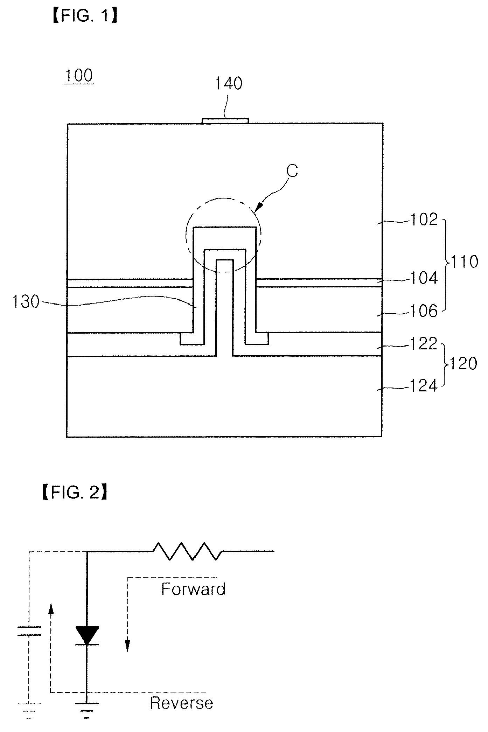

FIG. 1 is a sectional view showing a light emitting device according to a first illustrative example, and FIG. 2 is a circuit diagram showing the light emitting device according to the embodiment.

The light emitting device according to the illustrative example includes a light emitting structure 110 including a first conductivity type semiconductor layer 102, an active layer 104, and a second conductivity type semiconductor layer 106, a dielectric layer 130 formed in a cavity defined by removing a portion of the light emitting structure 110, and a second electrode layer 120 formed on the dielectric layer 130.

According to the illustrative example, the first conductivity type semiconductor layer 102, the dielectric layer 130, and the second electrode layer 120 can carry out the function of a capacitor C. Although one capacitor C is shown in FIG. 1, the illustrative example is not limited thereto. According to another illustrative example, a plurality of capacitors may be provided.

In the light emitting device and a method of manufacturing the same according to the embodiment, the light emitting device can be prevented from being damaged due to ESD (Electrostatic Discharge) while preventing light absorption from being lowered.

According to the embodiment, when a constant voltage is applied, a current flows to the active layer 104, so that the active layer 104 emits light due to the recombination of carriers. However, in ESD shock, energy having a high-frequency component passes through the path of the dielectric layer 130 of the capacitor C, so that the active layer 104 can be protected.

In other words, according to the embodiment, after forming a dielectric layer in a local region of an LED chip, an electrode is formed over the dielectric layer, thereby forming a capacitor in parallel to the LED. Therefore. when a DC constant voltage is applied, a current flows to a light emitting layer, which is the active layer 104, to emit light. In an ESD shock in the form of a pulse occurring in discharging, energy having a high-frequency component passes through the dielectric layer of the capacitor, so that the light emitting layer can be protected.

According to the embodiment, the capacitor is formed in an LED chip to prevent the LED from being damaged due to ESD, so that package cost can be reduced, and the manufacturing process can be simplified. Accordingly, light absorption can be prevented from being lowered.

According to the embodiment, current flow can be effectively adjusted, so that light extraction efficiency can be improved

According to the embodiment, the reliability for the light emitting device can be improved due to current spreading.

FIG. 2 is a circuit diagram showing the light emitting device according to the embodiment.

According to the embodiment, the first conductivity type semiconductor layer 102, the dielectric layer 130, and the second electrode layer 120 can perform the function of the MOS (Metal/Oxide/Semiconductor) capacitor C.

The light emitting device according to the embodiment can be realized as the circuit shown in FIG. 2. When a forward voltage is applied according to a constant voltage, a current flows through the LED to emit light. When a reverse voltage is applied according to the ESD, the current flows through the MOS capacitor C.

When the reverse voltage is applied according to ESD, as the total capacitance ($C_{Tot}$) is increased, a current flowing to the active layer 104 due to the ESD stress is reduced, so that shock can be mitigated.

This will be explained through the following equation.

Equation 1

$$Q_{Dis}=C_{ESD}V_{ESD} \ (Q_{Dis}: \text{quantity of charges in discharging, } C_{ESD}: \text{capacitance in}$$

discharging)

$$C'_{Tot}=C_{Diode}+C_{MOS} \ (\text{with MOS})$$

$$C_{Tot}=C_{Diode} \ (\text{without MOS})$$

$$I=dQ/dt=\triangle Q/\tau=Q_{Dis}/(RC_{Tot}) \qquad \therefore C_{Tot} \uparrow \text{-> } I \downarrow$$

$$\therefore I'=Q_{Dis}/(RC') < I=Q_{Dis}/(RC_{Tot})$$

In other words, when the reverse voltage is applied according to the ESD, as the total capacitance ($C_{Tot}$) is increased, a current (I') flowing to the active layer 104 due to the ESD stress is reduced, so that shock can be mitigated

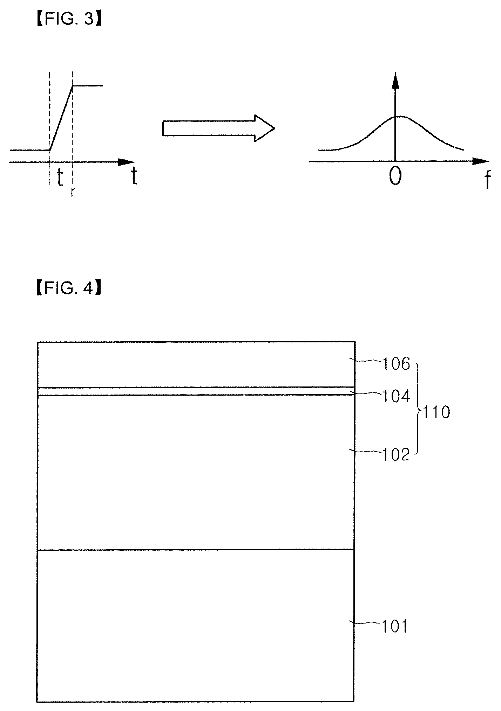

FIG. 3 is a view showing a waveform of the light emitting device according to the embodiment in the ESD.

As shown in FIG. 3, after a pulse waveform has been subject to Fourier Transform, the pulse waveform is transformed into a signal having a high-frequency component. In addition, as the edge of the pulse more sharply rises at rising time ($t_r$), the intensity of the high-frequency component is increased.

As shown in the following Equation, as a frequency is increased, impedance is reduced due to capacitance. Therefore, when a reverse voltage is applied according to the ESD, the impedance of the MOS capacitor C is reduced. Accordingly, a high-frequency current can flow to the MOS capacitor C.

Equation 2

$$\text{Impedance: } Z=Z_R +jZ_{Im} \ (Z_R \text{ is Real Impedance, } j \text{ represents the factor of an}$$

imaginary part, and $Z_{Im}$ is impedance made by a capacitor),

$$\text{Capacitor: } Z_{Im,C}=1/(j\omega C), \ (\text{wherein, } \omega=2\pi f)$$

In other words, when the reverse voltage is applied according to the ESD, the impedance of the MOS capacitor C is reduced, so that a high-frequency current can flow to the MOS capacitor C.

Meanwhile, according to the embodiment, since a region for a cavity A provided perpendicularly under a first electrode 140 has no active layer 104, light derived from the recombination of carriers (electrons and holes) is not created in the region of the cavity A.

According to the embodiment, after the etching for the light emitting structure is performed from the second conductivity type semiconductor layer 106 to the active layer 104, the dielectric layer 130 is formed. Accordingly, current is not smoothly supplied to the region for the cavity A. Therefore, light is not emitted from the active layer 104 over the cavity A, so that the light absorption by the first electrode 140 over the cavity A can be minimized.

In the light emitting device and the method of manufacturing the same according to the embodiment, the LED can be prevented from being damaged due to ESD (Electrostatic Discharge) while preventing light absorption from being lowered.

In other words, according to the embodiment, after forming a dielectric layer in a local region of an LED chip, an electrode is formed over the dielectric layer, thereby forming a capacitor in parallel to the LED. Therefore, when a DC constant voltage is applied, a current flows to a light emitting layer, which is the active layer 104, to emit light. In an ESD, shock in the form of a pulse occurring in discharging, energy having a high-frequency component passes through the dielectric layer of the capacitor, so that the light emitting layer can be protected.

According to the embodiment, the capacitor is formed in the LED chip to prevent the LED from being damaged due to ESD, so that package cost can be reduced, and the manufacturing process can be simplified. In addition, light absorption can be prevented from being lowered.

According to the embodiment, current flow can be effectively adjusted, so that light extraction efficiency can be improved. In addition, according to the embodiment, the reliability for the light emitting device can be improved due to current spreading.

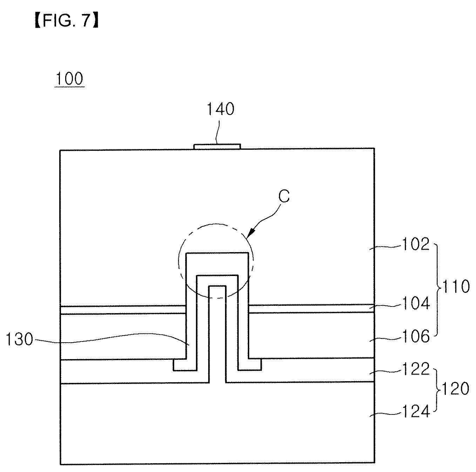

Hereinafter, the method of manufacturing the light emitting device according to the illustrative example will be described with reference to FIGS. 4 and 7.

The light emitting device according to the embodiment may include GaN, GaAs, GaAsP, or GaP. For example, a green or blue LED may include GaN (InGaN), and a yellow or red LED may include InGaAIP, or AIGaAs. According to the composition of materials, full colors can be realized.

As shown in FIG. 4, a first substrate 101 is prepared. The first substrate 101 may include a conductive substrate or an insulating substrate. For example, the first substrate 101 may include at least one selected from the group consisting of $Al_2O_3$, SiC, Si, GaAs, GaN, ZnO, Si, GaP, InP, Ge, and $Ga_2O_3$. The first substrate 101 may be provided thereon with a concave-convex structure, but the embodiment is not limited thereto.

A wet washing process is performed with respect to the first substrate 101, so that impurities can be removed from the surface of the first substrate 101.

Therefore, the light emitting structure 110 including the first conductivity type semiconductor layer 102, the active layer 104, and the second conductivity type semiconductor layer 106 is formed on the first substrate 101.

A buffer layer (not shown) may be formed on the first substrate 101. The buffer layer can attenuate the lattice mismatch between the material of the light emitting structure 110 and the first substrate 101. The buffer layer may include at least one selected from the group consisting of GaN, InN, AIN, InGaN, AIGaN, InAIGaN, and AIInN which are group III-V compound semiconductors. An undoped semiconductor layer may be formed on the buffer layer, but the embodiment is not limited thereto.

The first conductivity type semiconductor layer 102 may be realized by using group III-V compound semiconductors doped with first conductive dopants. If the first conductivity type semiconductor layer 102 is an N type semiconductor layer, the first conductivity type dopant may include Si, Ge, Sn, Se, or Te as the N type dopant, but the embodiment is not limited thereto.

The first conductivity type semiconductor layer 102 may include a semiconductor material having a composition formula of $In_xAl_yGa_{1-x-y}N$ ($0{\leq}x{\leq}1$, $0{\leq}y{\leq}1$, $0{\leq}x+y{\leq}1$).

The first conductivity type semiconductor layer 102 may include at least one selected from the group consisting of GaN, InN, A1N, InGaN, A1GaN, InA1GaN, AIInN, A1GaAs, InGaAs, AIInGaAs, GaP, AIGaP, InGaP, AIInGaP, and InP.

The first conductivity type semiconductor layer 102 may include an N type GaN layer formed through a CVD (Chemical Vapor Deposition) scheme, an MBE (Molecular Beam Epitaxy) scheme, a sputtering scheme, or a HVPE (Hydride Vapour Phase Epitaxy) scheme. In addition, the first conductivity type semiconductor layer 102 may be formed by applying trimethylgallium gas (TMGa), ammonia gas ($NH_3$), nitrogen gas ($N_2$), or silane gas ($SiH_4$) including N type impurities such as Si to the chamber.

Therefore, the active layer 104 is formed on the first conductivity type semiconductor layer 102. The active layer 104 may include at least one of a single quantum well structure, a multi-quantum well structure, a quantum-wire structure, and a quantum dot structure. For example, the active layer 104 may be formed in the multi-quantum well structure by injecting TMGa, $NH_3$, $N_2$, or TMIn, but the embodiment is not limited thereto.

The active layer 104 has a well/barrier layer which is prepared as a pair structure, such as an InGaN/GaN layer, an InGaN/InGaN layer, an AIGaN/GaN layer, an InAIGaN/GaN layer, a GaAs(InGaAs)/AIGaAs layer or a GaP(InGaP)/AI-GaP layer, but the embodiment is not limited thereto. The well layer includes material having a band gap lower than that of the barrier layer.

A conductive clad layer may be provided over and/or under the active layer 104. For example, the conductive clad layer may include an AIGaN-based semiconductor, and may have a band gap higher than that of the active layer 104.

Thereafter, the second conductivity type semiconductor layer 106 is formed on the active layer 104.

The conductivity type conductive semiconductor layer 106 may include compound semiconductors of group III-V elements doped with second conductivity type dopants. For example, the second conductivity type semiconductor layer 106 may include semiconductor materials having a composition formula of $In_xAl_yGa_{1-x-y}N$ ($0{\leq}x{\leq}1$, $0{\leq}y{\leq}1$, $0{\leq}x+y{\leq}1$), The second conductivity type semiconductor layer 106 may be selected from the group consisting of GaN, AIN, AIGaN, InGaN, InN, InAIGaN, AIInN, AIGaAs, GaP, GaAs, GaAsP, and AIGaInP. If the second conductivity type semiconductor layer 106 is a P type semiconductor layer, the second conductivity type dopant may include Mg, Zn, Ca, Sr, or Ba as a P type dopant. The second conductivity type semiconductor layer 106 may have a single layer structure or a multiple layer structure, but the embodiment is not limited thereto.

The second conductivity type semiconductor layer 106 may include a P type GaN layer formed by injecting TMGa, $NH_3$, $N_2$, and (EtCp$_2$Mg){Mg($C_2H_5C_5H_4$)$_2$} including P type impurities such as Mg into the chamber, but the embodiment is not limited thereto.

According to the embodiment, the first conductivity type semiconductor layer 102 may be realized by using an N type semiconductor layer, and the second conductivity type semiconductor layer 106 may be realized by using a P type semiconductor layer, but the embodiment is not limited thereto. In addition, over the second conductivity type semiconductor layer 106, a semiconductor, such as an N type semiconductor layer (not shown), having polarity opposite to the polarity of the second conductivity type semiconductor layer may be formed. Accordingly, the light emitting structure 110 may be realized by using one of an N-P junction structure, a P-N junction structure, an N-P-N junction structure, and a P-N-P junction structure.

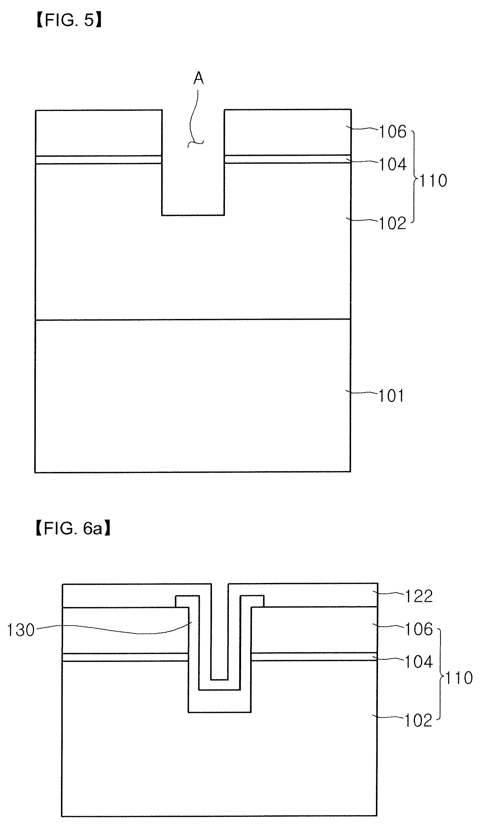

As shown in FIG. 5, the cavity A is formed by removing portions of the second conductivity type semiconductor layer 106, the active layer 104, and the second conductivity type semiconductor layer 106. The cavity A may include a recess, a groove, a trough or a trench.

For example, an etching process may be performed from a portion of the second conductivity type semiconductor layer 106, which is provided perpendicularly under the first electrode 140, to be formed later, to a point at which the first conductivity type semiconductor layer 102 is exposed. In order to form the cavity A, a dry etching process or a wet etching process can be performed.

According to the embodiment, a current is not smoothly supplied to the region for the cavity A, so that light emission does not occur over the cavity A. Accordingly, light absorption by the first electrode 140 provided over the cavity A can be minimized. In addition, according to the embodiment, since the region for the cavity A provided perpendicularly under the first electrode 140 has no active layer 104, light derived from the recombination of carriers (electrons and holes)is not created in the region for the cavity A.

In addition, according to the embodiment, the light emitting structure may be etched from the second conductivity type semiconductor layer 106 to the active layer 104. Accordingly, the dielectric layer 130 is thereafter formed over the cavity A, so that a constant voltage/current is not smoothly supplied to the region for the cavity A. Accordingly, light emission rarely occurs in the active layer 104 over the cavity A, thereby minimizing light absorption by the first electrode 140 existing over the cavity A.

Thereafter, as shown in FIG. 6A, the dielectric layer 130 is formed over the cavity A. For example, the dielectric layer 130 may be formed over the cavity A by using a nitride layer or an oxide layer including $SiO_2$, $TiO_2$, $Al_2O_3$, $Si_3N_4$, $SrBi_2(Ta, Nb)_2O_9(SBT)$, $Pb(Zr,Ti)O_3(PZT)$, or $Bi_4Ti_3O_{12}(BTO)$. Even if the dielectric layer 130 has a thin thickness under a condition at which the dielectric layer 130 includes ferroelectricity, the dielectric layer 130 can ensure high capacitance.

According to the illustrative example, the dielectric layer 130 may be formed in the second conductivity type semiconductor layer 106 in addition to lateral and bottom surfaces of the cavity A. Therefore, the dielectric layer 130 may be firmly maintained.

The dielectric layer 130 has a thicker thickness at the lateral surface of the cavity A than at the bottom surface of the cavity A, but the illustrative example is not limited thereto.

Whereafter, the second electrode layer 120 is formed between the second conductivity type semiconductor layer 106 and the dielectric layer 130.

The second electrode layer 120 may include an ohmic layer (not shown), a reflective layer 122, a coupling layer (not shown), and a conductive support substrate 124.

For example, the second electrode layer 120 may include the ohmic layer (not shown). The ohmic layer makes ohmic contact with the light emitting structure 110, so that power is smoothly supplied to the light emitting structure. The ohmic layer may have a stack structure includes single metal, metal alloy, or metal oxide.

For example, the ohmic layer may include at least one of ITO (indium tin oxide), IZO (indium zinc oxide), IZTO (indium zinc tin oxide), IAZO (indium aluminum zinc oxide), IGZO (indium gallium zinc oxide), IGTO (indium gallium tin oxide), AZO (aluminum zinc oxide), ATO (antimony tin oxide), GZO (gallium zinc oxide), IZON (IZO Nitride), AGZO(Al-Ga ZnO), IGZO(In-Ga ZnO), ZnO, IrOx, RuOx, NiO, RuOx/ITO, Ni/IrOx/Au, Ni/IrOx/Au/ITO, Ag, Ni, Cr, Ti, Al, Rh, Pd, Ir, Ru, Mg, Zn, Pt, Au, and Hf.

In addition, the second electrode layer 120 includes the reflective layer 122 to reflect light incident from the light emitting structure 110, so that light extraction efficiency can be improved.

For example, the reflective layer 122 may include metal or alloy including at least one of Ag, Ni, Al, Rh, Pd, Ir, Ru, Mg, Zn, Pt, Au, and Hf. The reflective layer 122 may be formed in a multi-layer structure by using the metal or alloy and a transmissive conductive material such as IZO, IZTO, IAZO, IGZO, IGTO, AZO, or ATO. For example, the reflective layer 122 may have a stack structure of IZO/Ni, AZO/Ag, IZO/Ag/Ni, and AZO/Ag/Ni.

In addition, if the second electrode layer 120 includes a bonding layer (not shown), the reflective layer 122 may act as the bonding layer, or may include barrier metal or bonding metal. For example, the bonding layer may include at least one of Ti, Au, Sn, Ni, Cr, Ga, In, Bi, Cu, Ag, and Ta.

The second electrode layer 120 may include the conductive support substrate 124. The conductive support substrate 124 may supply power to the light emitting structure 110 together with the first electrode 140 while supporting the light emitting structure 110. The conductive support substrate 124 may include metal, metal alloy, or a conductive semiconductor material having superior electrical conductivity.

For example, the conductive support substrate 124 may include at least one of Cu, Cu alloy, Au, Ni, Mo, Cu-W, carrier wafers (e.g., Si, Ge, GaAs, GaN, ZnO, SiGe, or SiC)

The thickness of the conductive support substrate 124 may vary according to the design of the light emitting device 100. For example, the conducive support substrate 124 may have a thickness in the range of about $30\mu m$ to about $500\mu m$.

The conductive support substrate 124 may be formed through an electro-chemical metal deposition scheme, a plating scheme, or a bonding scheme using eutectic metal.

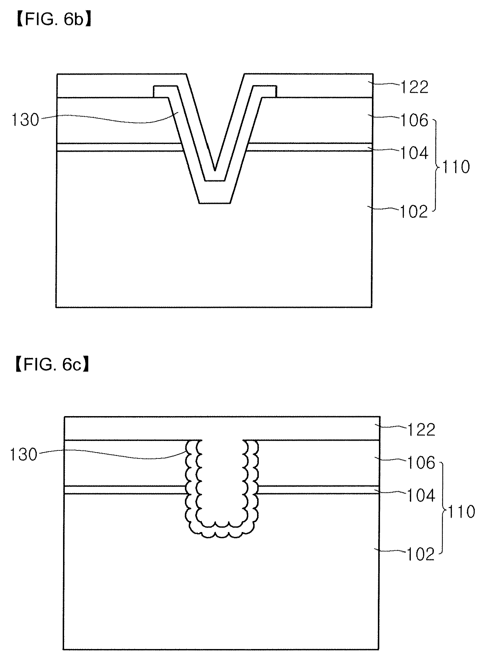

FIG. 6B is a sectional view showing a cavity according to another illustrative example. According to the present illustrative example, the cavity may be inclined as shown in FIG. 6B. Accordingly, the dielectric layer 130 or the reflective layer 122 may be formed along an inclined sidewall of the cavity.

FIG. 6C is a sectional view showing a cavity according to still another illustrative example. According to the present illustrative example, a concave-convex pattern is formed on a sidewall of the cavity as shown in FIG. 6C so that the contact area between the cavity and the dielectric layer 130 can be increased. Accordingly, the capacitance can be increased.

Next, as shown in FIG. 7, the first substrate 101 is removed such that the first conductive semiconductor layer 102 is exposed. The first substrate 101 may be removed through a laser lift off scheme or a chemical lift off scheme. In addition, the first substrate 101 may be physically ground to be removed.

Thereafter, the first electrode 140 may be formed on the first conductivity type semiconductor layer 102 exposed by removing the first substrate 101.

The first electrode 140 may include a pad part subject to wire bonding, and a finger part extending from the pad part. The finger part may branch in a predetermined pattern, and may have various shapes.

A roughness pattern (not shown) may be formed on a top surface of the first conductivity type semiconductor layer 102 to improve light extraction efficiency. Accordingly, the roughness pattern may be formed even on the top surface of the first electrode 140, but the embodiment is not limited thereto.

The first electrode 140 may be formed on the first conductivity type semiconductor layer 102 such that the first electrode 140 spatially overlaps with the cavity A, but the embodiment is not limited thereto. Even if the first electrode 140 slightly overlaps with the cavity A, the effects according to the embodiment can be obtained.

According to the embodiment, since the active layer 104 is not formed at the region of the cavity A provided perpendicularly under the first electrode 140, light derived from the recombination of carriers (electrons and holes) may not be created at the region of the cavity A.

According to the embodiment, since the cavity A, which is an etched region, is covered with the dielectric layer 130, a current does not flow through the cavity A, but is diffused into other regions. In other words, the cavity A is covered with the dielectric layer 130 to act as a CBL (Current Blocking Layer), so that the current can effectively flow. Accordingly, the reliability is not only improved, but also the light absorption by the first electrode 140 can be minimized. Therefore, the quantity of light can be increased. According to the first embodiment, the thickness of the first conductivity type semiconductor layer 102 may be thicker than that of the dielectric layer 130 or the reflective layer 122, but the embodiment is not limited thereto. According to the second and third illustrative examples , the first conductivity type semiconductor layer 102, the dielectric layer 130, and the reflective layer 122 may be formed at various thickness ratios.

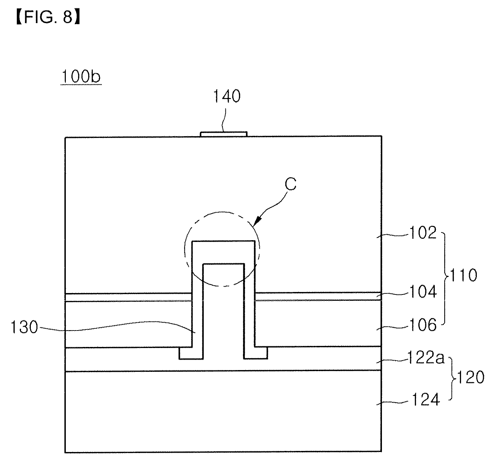

FIG. 8 is a sectional view showing a light emitting device 100b.

As shown in FIG. 8, a second reflective layer 122a may be filled in the cavity A. Accordingly, the conductive layer 124 may be easily formed thereafter.

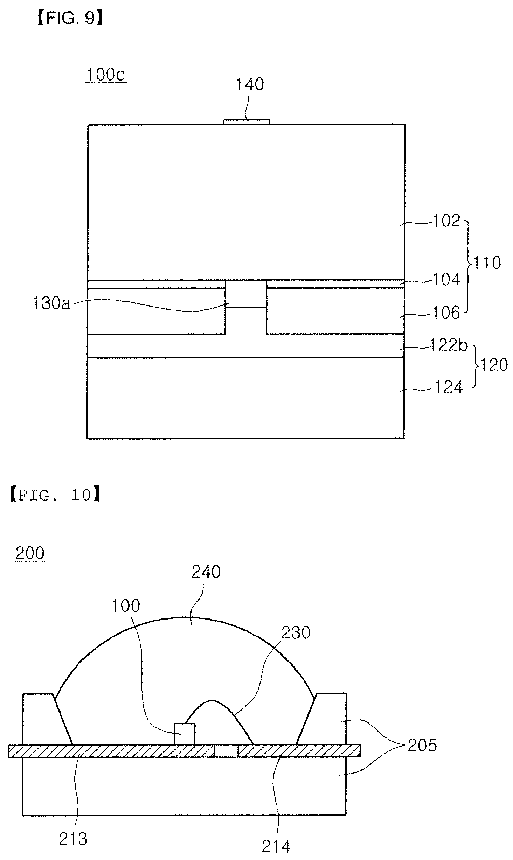

FIG. 9 is a sectional view showing a light emitting device 100c according to an embodiment as claimed.

According to the embodiment, as shown in FIG. 9, a second dielectric layer 130a is tilled in a portion of the cavity A, and a third reflective layer 122b may be filled in a remaining portion of the cavity A. In this case, the second dielectric layer 130a is formed to the height of the active layer 104, or a portion of the first conductivity type semiconductor layer 102.

Meanwhile, the capacitance according to the embodiment can be expressed through the following equation.

Equation 3

$$C = \varepsilon \times A/d,$$ wherein $\varepsilon$ is permittivity of a dielectric layer, $A$ represents the area of the dielectric layer, and $d$ represents the thickness of the dielectric layer.

In Equation 3, as the permittivity and the area of the dielectric layer are increased, and the thickness of the dielectric layer is decreased, capacitance C is increased. Therefore, according to the embodiment, the structure and the characteristics of the dielectric layer may be an important factor to prevent impact from being exerted on an active layer in ESD.

FIG. 10 is a view showing a light emitting device package 200 in which a light emitting device is installed according to the embodiments.

Referring to FIG. 10, the light emitting device package 200 includes a package body 205, third and fourth electrode layers 213 and 214 formed on the package body 205, the light emitting device 100 provided on the package body 205 and electrically connected to the third and fourth electrode layers 213 and 214 and a molding member 240 that surrounds the light emitting device 100.

The package body 205 may include silicon, synthetic resin or metallic material. An inclined surface may be formed around the light emitting device 100.

The third and fourth electrode layers 213 and 214 are electrically isolated from each other to supply power to the light emitting device 100. In addition, the third and fourth electrode layers 213 and 214 reflect the light emitted from the light emitting device 100 to improve the light efficiency and dissipate heat generated from the light emitting device 100 to the outside.

The vertical type light emitting device shown in FIGS. 1, 8, and 8, is applicable to the light emitting device 100, but the embodiment is not limited thereto. For instance, the lateral type light emitting device may be applicable to the light emitting device 100.

The light emitting device 100 may be installed on the package body 205 or the third and fourth electrode layers 213 and 214.

The light emitting device 100 is electrically connected to the third electrode layer 213 and/or the fourth electrode layer 214 through at least one of a wire bonding scheme, a flip chip bonding scheme and a die bonding scheme. According to the embodiment, the light emitting device 100 is electrically connected to the third electrode layer 213 through a wire 230 and electrically connected to the fourth electrode layer 214 through the die bonding scheme.

The molding member 240 surrounds the light emitting device 100 to protect the light emitting device 100. In addition, the molding member 240 may include phosphors to change the wavelength of the light emitted from the light emitting device 100.

A plurality of light emitting device packages according to the embodiment may be arrayed on a substrate, and an optical member including a light guide plate, a prism sheet, a diffusion sheet or a fluorescent sheet may be provided on the optical path of the light emitted from the light emitting device package. The light emitting device package, the substrate, and the optical member may serve as a backlight unit or a lighting unit. For instance, the lighting system may include a backlight unit, a lighting unit, an indicator, a lamp or a streetlamp.

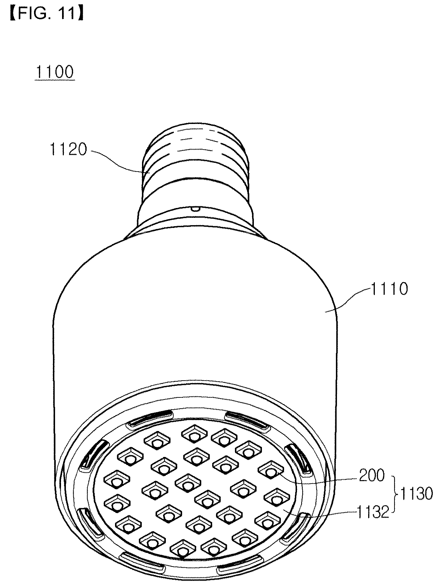

FIG. 11 is a perspective view showing a lighting unit 1100 according to the embodiment. The lighting unit 1100 shown in FIG. 11 is an example of a lighting system and the embodiment is not limited thereto.

Referring to FIG. 11, the lighting unit 1100 includes a case body 1110, a light emitting module 1130 installed in the case body 1110, and a connection terminal 1120 installed in the case body 1110 to receive power from an external power source.

Preferably, the case body 1110 includes material having superior heat dissipation property. For instance, the case body 1110 includes metallic material or resin material.

The light emitting module 1130 may include a substrate 1132 and at least one light emitting device package 200 installed on the substrate 1132.

The substrate 1132 includes an insulating member printed with a circuit pattern. For instance, the substrate 1132 includes a PCB (printed circuit board), an MC (metal core) PCB, an F (flexible) PCB, or a ceramic PCB.

In addition, the substrate 1132 may include material that effectively reflects the light. The surface of the substrate 1132 can be coated with a color, such as a white color or a silver color, to effectively reflect the light.

At least one light emitting device package 200 can be installed on the substrate 1132. Each light emitting device package 200 may include at least one LED (light emitting diode). The LED may include a colored LED that emits the light having the color of red, green, blue or white and a UV (ultraviolet) LED that emits UV light.

The LEDs of the light emitting module 1130 can be variously arranged to provide various colors and brightness. For instance, the white LED, the red LED and the green LED can be arranged to achieve the high color rendering index (CRI).

The connection terminal 1120 is electrically connected to the light emitting module 1130 to supply power to the light emitting module 1130. Referring to FIG. 11, the connection terminal 1120 has a shape of a socket screw-coupled with the external power source, but the embodiment is not limited thereto. For instance, the connection terminal 1120 can be prepared in the form of a pin inserted into the external power source or connected to the external power source through a wire.

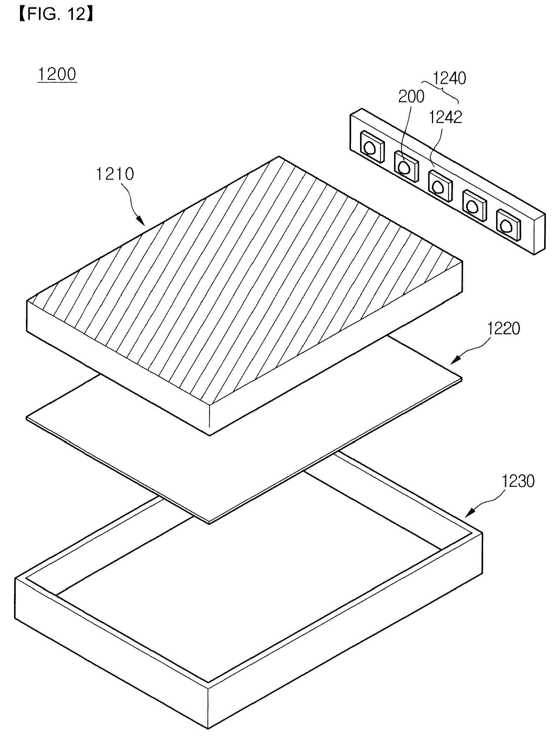

FIG. 12 is an exploded perspective view showing a backlight unit 1200 according to the embodiment. The backlight unit 1200 shown in FIG. 12 is an example of a lighting system and the embodiment is not limited thereto.

The backlight unit 1200 according to the embodiment includes a light guide plate 1210, a light emitting module 1240 for providing the light to the light guide plate 1210, a reflective member 1220 positioned under the light guide plate 1210, and a bottom cover 1230 for receiving the light guide plate 1210, light emitting module 1240, and the reflective member 1220 therein, but the embodiment is not limited thereto.

The light guide plate 1210 diffuses the light to provide surface light. The light guide 1210 includes transparent material. For instance, the light guide plate 1210 can be manufactured by using acryl-based resin, such as PMMA (polymethyl methacrylate), PET (polyethylene terephthalate), PC (polycarbonate), COC or PEN (polyethylene naphthalate) resin.

The light emitting module 1240 supplies the light to at least one lateral side of the light guide plate 1210 and serves as the light source of the display device including the backlight unit.

The light emitting module 1240 can be positioned adjacent to the light guide plate 1210, but the embodiment is not limited thereto. In detail, the light emitting module 1240 includes a substrate 1242 and a plurality of light emitting device packages 200 installed on the substrate 1242 and the substrate 1242 can be adjacent to the light guide plate 1210, but the embodiment is not limited thereto.

The substrate 1242 may include a printed circuit board (PCB) having a circuit pattern (not shown). In addition, the substrate 1242 may also include a metal core PCB (MCPCB) or a flexible PCB (FPCB), but the embodiment is not limited thereto.

In addition, the light emitting device packages 200 are arranged such that light exit surfaces of the light emitting device packages 200 are spaced apart from the light guide plate 1210 at a predetermined distance.

The reflective member 1220 is disposed under the light guide plate 1210. The reflective member 1220 reflects the light, which is traveled downward through the bottom surface of the light guide plate 1210, toward the light guide plate 1210, thereby improving the brightness of the backlight unit. For instance, the reflective member 1220 may include PET, PC or PVC resin, but the embodiment is not limited thereto.

The bottom cover 1230 may receive the light guide plate 1210, the light emitting module 1240, and the reflective member 1220 therein. To this end, the bottom cover 1230 has a box shape with an open top surface, but the embodiment is not limited thereto.

The bottom cover 1230 can be manufactured through a press process or an extrusion process by using metallic material or resin material.

In the light emitting device, the light emitting device package, and the lighting system according to the embodiment, the LED can be prevented from being damaged due to ESD while preventing light absorption from being lowered.

In other words, according to the embodiment, after forming a dielectric layer in a local region of an LED chip, an electrode is formed over the dielectric layer, thereby forming a capacitor in parallel to the LED. Therefore, when a DC constant voltage is applied, a current flows to a light emitting layer, which is the active layer, to emit light. In contrast, in an ESD shock in the form of a pulse occurring in discharging, energy having a high-frequency component passes through the dielectric layer of the capacitor, so that the light emitting layer can be protected.

According to the embodiment, the capacitor is formed in an LED chip to prevent the LED from being damaged due to static electricity, so that package cost can be reduced, and the manufacturing process can be simplified. In addition, the light absorption can be prevented from being lowered.

According to the embodiment, current flow can be effectively adjusted, so that light extraction efficiency can be improved.

According to the embodiment, the reliability for the light emitting device can be improved due to current spreading.

As described above, the lighting system according to the embodiments includes the light emitting device package according to the embodiments, so that the reliability of the lighting system can be improved.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

**Claims**

1. A light emitting device comprising:

a light emitting structure (110) including a second conductivity type semiconductor layer (106), an active layer (104) over the second conductivity type semiconductor layer (106), and a first conductivity type semiconductor layer (102) over the active layer (104);
a dielectric layer (130) in a cavity extending through the second conductivity type semiconductor layer (106), and the active layer (104), and extending partially into or exposing the first conductivity type semiconductor layer (102) of the light emitting structure (110), the cavity having a cross section area A; and
a second electrode layer (120) under the dielectric layer (130),
a first electrode over the first conductivity type semiconductor layer, wherein the first electrode spatially overlaps with a portion of the cavity,
wherein the second electrode (120) includes:

a reflective layer (122b) under the dielectric layer (130); and
a conductive layer (124) under the reflective layer (122b) and disposed in contact with the reflective layer,

wherein the reflective layer (122b) includes a first portion that is covered with the dielectric layer (130) and is vertically overlapped with the first electrode, and a second portion that is directly connected to the second conductivity type semiconductor layer (106),
**characterized in that**

the dielectric layer (130) completely fills the cavity from a given height of the cavity,
the dielectric layer (130) has a thickness d corresponding to this given height,
a capacitor C is formed by the first conductivity type semiconductor layer (102), the dielectric layer (130) and the reflective layer (122b) and having a capacitance $C=\varepsilon xA/d$, wherein $\varepsilon$ is permittivity of the dielectric layer,
and the reflective layer (122b) completely fills the remaining part of the cavity, and the second portion of the reflective layer (122b) extends outside the cavity.

2. A light emitting device package comprising:

a package body;
third and fourth electrode layers instaled in the package body; and
a light emitting device according to claim 1 electrically connected to the third and fourth electrode layers.

**Patentansprüche**

1. Lichtemittierende Vorrichtung, umfassend:

eine lichtemittierende Struktur (110), einschließend eine Halbleiterschicht eines zweiten Leitfähigkeitstyps (106), eine aktive Schicht (104) über der Halbleiterschicht eines zweiten Leitfähigkeitstyps (106) und eine Halbleiterschicht eines ersten Leitfähigkeitstyps (102) über der aktiven Schicht (104);
eine dielektrische Schicht (130) in einem Hohlraum, der sich durch die Halbleiterschicht eines zweiten Leitfähigkeitstyps (106) und die aktive Schicht (104) hindurch erstreckt und sich teilweise in die Halbleiterschicht eines ersten Leitfähigkeitstyps (102) der lichtemittierenden Struktur (110) hinein erstreckt oder diese freilegt, wobei der Hohlraum eine Querschnittsfläche A aufweist; und
eine zweite Elektrodenschicht (120) unter der dielektrischen Schicht (130),
eine erste Elektrode über der Halbleiterschicht eines ersten Leitfähigkeitstyps, wobei die erste Elektrode sich räumlich mit einem Abschnitt des Hohlraums überlappt,

wobei die zweite Elektrode (120) einschließt:

eine reflektierende Schicht (122b) unter der dielektrischen Schicht (130); und
eine leitfähige Schicht (124) unter der reflektierenden Schicht (122b), die in Kontakt mit der reflektierenden Schicht angeordnet ist,
wobei die reflektierende Schicht (122b) einen ersten Abschnitt, der von der dielektrischen Schicht (130) bedeckt und vertikal mit der ersten Elektrode überlappt ist, und einen zweiten Abschnitt, der direkt mit der Halbleiterschicht eines zweiten Leitfähigkeitstyps (106) verbunden ist, einschließt,

**dadurch gekennzeichnet, dass**

die dielektrische Schicht (130) den Hohlraum ab einer gegebenen Höhe des Hohlraums vollständig ausfüllt,
die dielektrische Schicht (130) eine Dicke d aufweist, die dieser gegebenen Höhe entspricht,
ein Kondensator C durch die Halbleiterschicht eines ersten Leitfähigkeitstyps (102), die dielektrische Schicht (130) und die reflektierende Schicht (122b) gebildet ist und eine Kapazität C=εxA/d aufweist, wobei ε die Permittivität der dielektrischen Schicht ist,
und die reflektierende Schicht (122b) den verbleibenden Teil des Hohlraums vollständig ausfüllt und der zweite Abschnitt der reflektierenden Schicht (122b) sich außerhalb des Hohlraums erstreckt.

2. Gehäuse für eine lichtemittierende Vorrichtung, umfassend:

einen Gehäusekörper;
dritte und vierte Elektrodenschichten, die in dem Gehäusekörper installiert sind; und eine lichtemittierende Vorrichtung nach Anspruch 1, die elektrisch an die dritten und vierten Elektrodenschichten angeschlossen ist.

## Revendications

1. Dispositif électroluminescent comprenant :

une structure électroluminescente (110) comprenant une couche de semi-conducteur de second type de conductivité (106), une couche active (104) sur la couche de semi-conducteur de second type de conductivité (106), et une couche de semi-conducteur de premier type de conductivité (102) sur la couche active (104) ;
une couche diélectrique (130) dans une cavité s'étendant au travers de la couche de semi-conducteur de second type de conductivité (106), et de la couche active (104), et s'étendant partiellement dans ou exposant la première couche de semi-conducteur de premier type de conductivité (102) de la structure électroluminescente (110), la cavité ayant une superficie en coupe A ; et
une couche de deuxième électrode (120) sous la couche diélectrique (130),
une première électrode sur la couche de semi-conducteur de premier type de conductivité, la première électrode chevauchant spatialement une portion de la cavité,

dans lequel la deuxième électrode (120) comprend :

une couche réfléchissante (122b) sous la couche diélectrique (130) ; et
une couche conductrice (124) sous la couche réfléchissante (122b) et disposée en contact avec la couche réfléchissante,
dans lequel la couche réfléchissante (122b) comprend une première portion qui est recouverte par la couche diélectrique (130) et est verticalement chevauchée par la première électrode, et une seconde portion qui est directement connectée à la couche de semi-conducteur de second type de conductivité (106),

**caractérisé en ce que**

la conduite diélectrique (130) remplit complètement la cavité d'une hauteur donnée de la cavité,
la couche diélectrique (130) a une épaisseur d correspondant à cette hauteur donnée, un condensateur C est formé par la couche de semi-conducteur de premier type de conductivité (102), la couche diélectrique (130) et la couche réfléchissante (122b) et ayant une capacité C = ε x A/d, où ε est la permittivité de la couche diélectrique, et la couche réfléchissante (122b) remplit complètement la partie restante de la cavité, et
la seconde portion de la couche réfléchissante (122b) s'étend à l'extérieur de la cavité.

2. Boîtier de dispositif électroluminescent comprenant :

un corps de boîtier ;
des couches de troisième et quatrième électrodes installées dans le corps de boîtier ; et
un dispositif électroluminescent selon la revendication 1 électriquement connecté aux couches de troisième et quatrième électrodes.

【FIG. 1】

【FIG. 2】

【FIG. 3】

【FIG. 4】

【FIG. 5】

A

106
104
102
110

101

【FIG. 6a】

122
130
106
104
102
110

【FIG. 6b】

【FIG. 6c】

【FIG. 7】

【FIG. 8】

【FIG. 9】

【FIG. 10】

【FIG. 11】

1100

【FIG. 12】

1200

**EP 2 315 273 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070284606 A1
- WO 2007036164 A1
- JP 2927158 B